# EUROPÄISCHE PATENTSCHRIFT

(11) **EP 4 202 452 B1**
(45) Veröffentlichungstag und Bekanntmachung des Hinweises auf die Patenterteilung: **12.11.2025**
(21) Anmeldenummer: 21216287.9
(22) Anmeldetag: 21.12.2021
(51) Int. Cl.: G01R 31/00, G01R 31/396

(54) **VORRICHTUNG UND VERFAHREN ZUM KALIBRIEREN EINES BATTERIEEMULATORS**
DEVICE AND METHOD FOR CALIBRATING A BATTERY EMULATOR
DISPOSITIF ET PROCÉDÉ D'ÉTALONNAGE D'UN ÉMULATEUR DE BATTERIE

(43) Veröffentlichungstag der Anmeldung: 28.06.2023
(73) Patentinhaber: dSPACE GmbH, 33102 Paderborn (DE)
(72) Erfinder: Scheibelhut, Peter, 33102 Paderborn (DE)

(56) Entgegenhaltungen:
- WO-A1-2015/135922
- WO-A1-2019/079836
- WO-A2-02/097460
- DE-A1- 102014 226 190
- DE-A1- 102015 206 778

## Beschreibung

Die Anmeldung betrifft eine Vorrichtung und ein Verfahren zum Kalibrieren eines Batterieemulators, welcher eine Hochvoltbatterie mit mehreren, in Reihe geschalteten Zellen emuliert.

Bekannt aus der Offenlegungsschrift DE 102014226190 A1 ist eine Testvorrichtung zur Überprüfung eines Batteriesteuergeräts. Offenbart ist ein System mit Zellen, einem Batteriesimulator zur Simulation einer Spannung und außerdem ein Auswertemodul, welches über eine als zentraler Bus ausgeführte Schiene mit dem Batteriesteuergerät oder der Batterie verbindbar ist. Weiterhin ist ein Trennstellenmodul offenbart, mit dem Zellen zur Auswertung hinsichtlich Spannung, Temperatur und weiterer Größen auswählbar sind.

Die internationale Offenlegungsschrift WO 02/097460 A2 offenbart außerdem ein Überwachungssystem zur Messung einzelner Zellspannungen, bspw. an einem Brennstoffzellenstapel. Offenbart ist ein System mit mehreren Differentialverstärkern zur Verbindung mit den zu messenden Zellen mittels eines Schaltnetzwerks, AD-Wandlern zur Digitalisierung der gemessenen Werte, und eine Steuerungseinheit zur Steuerung des Schaltnetzwerks und der AD-Wandler.

Aus der internationalen Offenlegungsschrift WO 2019/079836 A1 ist eine Vorrichtung zum Kalibrieren eines Batteriesimulators bekannt, welcher einen Kondensator im Strompfad aufweist und einer Messvorrichtung zur Messung der Stromstärke im Strompfad. Somit kann die Vorrichtung beim Laden des Kondensators sehr hohe Ströme aufnehmen und beim anschließenden Entladen des Kondensators sehr hohe Ströme liefern, während die Stromstärke gemessen wird. Dies ermöglicht eine bidirektionale Kalibrierung.

Des Weiteren ist ein Batterieemulator aus der Offenlegungsschrift WO 2015135922 A1 bekannt. Die Schrift offenbart einen Energiespeicheremulator mit einem Energiespeichermodell zur Emulation eines elektrischen Energiespeichers bestehend aus einer Anzahl von Zellen und mit zumindest einer realen Referenzzelle. Hier ist ein flexibles Verfahren offenbart, das Energiespeichermodell über den gesamten Betriebsbereich des Energiespeichers mit ausreichender Genauigkeit anzupassen.

Die Anmeldung hat die Aufgabe, dass eine Vorrichtung bzw. ein Verfahren zum Kalibrieren eines Batterieemulators geschaffen wird, die bzw. das den Prozess des Kalibrierens verbessert.

Diese Aufgabe wird durch die Merkmalskombinationen der unabhängigen Patentansprüche gelöst. In den abhängigen Ansprüchen sind Weiterbildungen der in den unabhängigen Ansprüchen angegebenen Vorrichtung bzw. des Verfahrens zum Kalibrieren eines Batterieemulators angegeben.

Die Anmeldung schlägt daher eine Vorrichtung bzw. ein Verfahren zum Kalibrieren eines Batterieemulators vor, die bzw. das eine Hochvolt-Batterie mit mehreren, in Reihe geschalteten Zellen emuliert, wobei jede emulierte Zelle Abgriffe aufweist, über die zumindest eine emulierte Größe abgreifbar ist, wobei die Vorrichtung eine Schaltvorrichtung aufweist, über die ein Kalibriernormal mit verschiedenen Abgriffen umschaltbar verbindbar ist.

Damit ist eine Vorrichtung bzw. ein Verfahren zum Kalibrieren eines Batterieemulators geschaffen worden, die bzw. das mit nur einem einzigen Kalibriernormal auskommen kann. Dies vereinfacht den Aufwand. Außerdem ist eine einfache Automatisierung einer solchen Kalibrierung möglich. Dies kann Bauraum sparen und eine kompakte Bauform ermöglichen.

Insbesondere für die Prüfung von sogenannten Batteriemanagementsystemen (BMS) vor allem für Traktionsbatterien, vorzugsweise Hochvolttraktionsbatterien, ist die Vorrichtung bzw. das Verfahren geeignet, aber auch für Anwendungen in Stromversorgungsnetzen ist eine Verwendung möglich.

Bei BMS führt ein Steuergerät (Electronic Control Unit ECU) die Aufgaben des Batteriemanagements aus. Vorliegend kann durch die Vorrichtung bzw. das Verfahren gemäß des Gegenstands der unabhängigen Patentansprüche eine Hochvolt-Batterie mit mehreren, in Reihe geschalteten Zellen emuliert werden. Das Steuergerät wird dann durch diese emulierte Hochvolt-Batterie als Hardware-in-the-Loop (HiL) z. B. in seiner Funktionsfähigkeit geprüft, aber auch andere Versuche mit der emulierten Hochvolt-Batterie sind mit solch einer HIL-Anordnung möglich.

Mithin liegt eine elektrische Nachbildung einer realen Hochvolt-Batterie durch die Emulation vor.

Das Steuergerät selbst hat eine Recheneinheit, Speicher, Schnittstellen und evtl. weitere Komponenten, die für die Verarbeitung von Eingangssignalen in das Steuergerät und die Erzeugung von Steuersignalen erforderlich sind. Die Schnittstellen dienen zur Aufnahme der Eingangssignale bzw. Abgabe der Steuersignale. Es ist möglich, dass das Steuergerät auf einem sogenannten Zentralrechner implementiert ist, der verschiedene Steuerfunktionen, also nicht nur die Steuerung der Hochvolt-Batterie ausführt. Unter einem Zentralrechner kann ein Rechner verstanden werden, der sich vor allem durch die Verwendung von Grafikprozessoren auszeichnet, die bspw. in Redundanz vorhanden sind.

Durch den Gegenstand der Anmeldung kann die Verwendung einer externen Kalibriervorrichtung vermieden werden, da die Schaltvorrichtung und das Kalibriernormal in den Batterieemulator integriert werden können. Die simulierten Zellen müssen nicht durch hochpräzise und somit sehr teure elektrische Bauteile implementiert werden, weil eine Korrektur der Bauteiltoleranzen durch die Kalibrierung und eine darauffolgende Justierung möglich wird.

Unter Kalibrieren kann vorliegend ein Vergleich von gemessen Werten der emulierten Hochvolt-Batterie bzw. deren Zellen mit den Werten des Kalibriernormals verstanden werden. Das Kalibriernormal liefert nämlich Werte mit einer bekannten oder vorgegebenen Genauigkeit bzw. Präzision. Dieser Vergleich kann dazu führen, dass keine Maßnahmen erforderlich sind, wenn der Vergleich zu keiner Abweichung führt, die bspw. über einem Schwellenwert liegt. Alternativ kann der Vergleich zu einer Abweichung führen, die signifikant ist, also bspw. über einem vorgegebenen Schwellenwert liegt. Als Konsequenz kann dann entweder nur eine Kalibrierung, also Aufzeichnung dieser signifikanten Abweichung, erfolgen oder die Justierung, also eine Anpassung von Parametern, erfolgen, die bspw. in einem folgenden Vergleich zu einer geringeren Abweichung führen soll.

Ein Batterieemulator bildet vorliegend das Verhalten von einer Hochvolt-Batterie definiert nach dem Gegenstand dieser Anmeldung nach. Dafür weist der Batterieemulator pro Zelle zwei Anschlüsse auf, die jeweils den Plus- und Minuspol der jeweiligen Zelle verkörpern. Durch die Verwendung von elektrischen Schaltungen und auf einem oder mehreren Prozessoren ablaufenden Funktionen für den Batterieemulator werden ein oder mehrere Modelle der Hochvoltbatterie und ihrer jeweiligen Zellen realisiert. Solch ein Modell kann über wenigstens einen Parameter einstellbar sein. Der Batterieemulator kann daher bspw. eine Ausgangsspannung der Zellen bzw. der Hochvoltbatterie bei schnellen und hohen Lastsprüngen nachbilden. Damit können verschiedenste Komponenten, die an die Hochvolt-Batterie unmittelbar oder mittelbar angeschlossen sind, geprüft werden, aber es kann natürlich auch geprüft werden, wie die Emulation der Hochvolt-Batterie selbst zu parametrieren ist.

Eine Hochvolt-Batterie liefert Gleichspannung von bspw. 60V-1,5kV je nach Anforderungen. Traktionsbatterien für Fahrzeuge haben bspw. mehrere hundert Volt Ausgangsspannung, aber durch das Bedürfnis schneller die Hochvolt-Batterie laden zu können, ist ein Trend zu höheren Spannungen bspw. 800V zu sehen. Für eine Hochvolt-Batterie werden die Zellen gemäß der Anmeldung in Reihe geschaltet, so dass bspw. die einzelnen Zellen nur eine Ausgangsspannung von wenigen Volt haben, die sich dann zu der Hochvoltspannung addieren. Bspw. werden Lithium-Ionen-Batterien oder andere Metall-Hybrid-Batterien verwendet.

Die Zellen weisen jeweils Abgriffe auf, über die zumindest eine emulierte Größe wie eine elektrische Spannung abgreifbar ist, aber auch andere Größen wie ein elektrischer Strom sind darüber abgreifbar.

Die Schaltvorrichtung wird durch die abhängigen Ansprüche näher definiert. Vorliegend kann die Schaltvorrichtung jedoch vorzugsweise als Hardware ausgebildet werden, d.h. die Schaltvorrichtung weist Schalter auf, die jeweils ansteuerbar sind. Vorliegend ist es die Funktion der Schaltvorrichtung die Abgriffe der einzelnen Zellen jeweils mit dem Kalibriernormal umschaltbar zu verbinden. Dabei ist es möglich, dass nur eine Zelle über ihre Abgriffe mit dem Kalibriernormal über die Schaltvorrichtung verbunden wird oder mehr als eine. Die Schaltvorrichtung erfüllt die Funktion eines Multiplexers, dessen Schaltelemente eine hohe, dauerhafte Spannungsfestigkeit, ein zuverlässiges Schalten kleiner Spannungen, einen hohen Isolationswiderstand und eine geringe Fehlerspannung aufweisen. Bevorzugt weisen die Schaltelemente auch eine ausreichende Stromtragfähigkeit auf, falls eine Kalibrierung der Strommessung gewünscht ist. Eine emulierte Zelle kann in der Lage sein, ihren Ausgangsstrom zu messen. Hierfür kann die Kalibrierung der Strommessung vorteilhaft verwendet werden.

Das Kalibriernormal wird weiter in den abhängigen Ansprüchen definiert. Die Funktion des Kalibriernormals ist der Vergleich der emulierten Größe an den jeweiligen Abgriffen mit den vorbekannten Werten mit vorgegebener Genauigkeit.

Mit umschaltbar verbindbar wird zum Ausdruck gebracht, dass das Kalibriernormal mit den Abgriffen der Zellen verbunden wird und dass dann das Kalibriernormal auch mit anderen Zellen verbunden werden kann. An die Schaltvorrichtung ist also einerseits der Batterieemulator über die Abgriffe der jeweiligen Zellen angeschlossen und andererseits das Kalibriernormal.

Bei dem Verfahren zum Kalibrieren des Batterieemulators, welcher eine Hochvolt-Batterie mit mehreren in Reihe geschalteten Zellen emuliert, wobei jede emulierte Zelle Abgriffe aufweist, über die zumindest eine emulierte Größe abgreifbar ist, wird ein Kalibriernormal über eine Schaltvorrichtung nacheinander mit verschiedenen Abgriffen verbunden.

Es wird vorgeschlagen, dass das Kalibriernormal mit den Abgriffen von jeweils einer emulierten Zelle verbindbar ist und diese Verbindung zu anderen emulierten Zellen umschaltbar ist. Damit kann dann bspw. Zelle für Zelle kalibriert werden.

Weiterhin wird vorgeschlagen, dass die Schaltvorrichtung Schaltelemente aufweist und die Verbindung zwischen den Abgriffen jeweils einer emulierten Zelle und dem Kalibriernormal ein oder mehrere Paare von Schaltelementen in Reihe aufweist. Damit ist es möglich, im Sinne eines Multiplexers Signale von den Abgriffen jeweiliger Zellen zusammenzuschalten oder Signale jeweiliger Zellen zum Kalibriernormal durchzuschalten. Diese Schaltelemente können nach einem festen Ablauf angesteuert werden oder adaptiv in Abhängigkeit von den Signalen selbst oder in Abhängigkeit von Benutzereingaben oder in Abhängigkeit von anderen Steuersignalen.

Darüber hinaus wird vorgeschlagen, dass die Schaltelemente als elektromechanische Schaltelemente ausgebildet sind. Die emulierten Zellen sollen hinsichtlich ihrer präzisen Spannungsvorgabe und Rückmessung von Ausgangsstrom und - spannung regelmäßig geprüft werden. Daher ist eine entsprechende Spannungsfestigkeit und ausreichende Stromtragfähigkeit für die Schaltelemente notwendig. Dies wird bspw. durch die elektromechanischen Schaltelemente erreicht.

Ferner wird erfindungsgemäß vorgeschlagen, dass die emulierte Größe eine Spannung ist und das Kalibriernormal einen Spannungsmesser aufweist, welcher mit einem Paar Hochvolt-Busschienen der Schaltvorrichtung verbunden ist und eingerichtet ist, eine zwischen den Hochvolt-Busschienen anliegende Spannung zu messen.

Gemäß der Erfindung wird weiterhin vorgeschlagen, dass die Abgriffe jeweils einer emulierten Zelle über ein oder mehrere Paare der Schaltelemente der Schaltvorrichtung mit den Hochvolt-Busschienen verbindbar sind. Über die Ebenen der Paare von Schaltelementen können entsprechende Zusammenschaltungen von Abgriffen erfolgen. Weiterhin können bei mehreren Ebenen Schaltelemente verwendet werden, die in der ersten oder den ersten Ebenen eine geringe Schaltspannungsfestigkeit aufweisen können. Über die Hochvolt-Busschienen ist es dann möglich, dass die Kalibriereinrichtung eine so zusammengesetzte Ausgangsspannung der emulierten Batterie misst. Es liegt demnach an der Schaltvorrichtung, welche Spannungen von welchen Zellen auf diese Hochvolt-Busschienen aufgeschaltet werden.

Weiterhin wird gemäß der Erfindung vorgeschlagen, dass die Schaltvorrichtung mehrere Paare Niedervolt-Busschienen aufweist, die jeweils paarweise über jeweilige Paare von Hochvolt-Schaltelementen mit den Hochvolt-Busschienen verbindbar sind. Mit diesem Zwischenschritt der Niedervolt-Busschienen müssen weniger Hochvolt-Schaltelemente eingesetzt werden, als wenn die Abgriffe der Zellen über Hochvolt-Schaltelemente direkt auf die Hochvolt-Busschienen geschaltet werden. Dadurch können an Stelle von Hochvolt-Schaltern, auch Hochvoltschaltelemente genannt, weniger aufwändige Niedervolt-Schalter, auch Niedervoltschaltelemente genannt, eingesetzt werden. Dies spart Platz und Kosten. Auch die Verbindungsleitungen können im Niedervolt-Bereich aufgrund der geringeren Spannung einfacher gestaltet sein.

Es kann vorgesehen sein, dass eine oder mehrere in Reihe geschaltete emulierte Zellen über jeweils ein Paar Niedervoltschaltelemente mit einem Paar der Niedervolt-Busschienen verbindbar sind.

Weiterhin kann der Batterieemulator mehrere in Reihe und/oder in Serie geschaltete Zellgruppen emulieren, wobei jede Zellgruppe mehrere in Reihe geschaltete Zellen emuliert, wobei die emulierten Zellen der jeweiligen emulierten Zellgruppe über ein zugeordnetes Paar Niedervoltschaltelemente mit den Niedervolt-Busschienen verbindbar sind.

In einer Ausführungsform weist die Vorrichtung neben der Schaltvorrichtung den Batterieemulator und das Kalibriernormal auf. Vorzugsweise sind die Schaltvorrichtung, der Batterieemulator und das Kalibriernormal in einem Gehäuse angeordnet. Dies bietet den Vorteil, dass die Abgriffe ebenfalls innerhalb des Gehäuses angeordnet sein können und nicht zum Zweck der Kalibrierung zusätzlich nach außen geführt werden müssen. Ein Vorteil dieser Ausführungsform ist, dass die Schalter und insbesondere die Niedervoltschaltelemente durch die emulierten Zellen mit Energie versorgt und angesteuert werden können. Die für die emulierten Zellen benötigte, galvanisch getrennte Energieversorgung und Ansteuerung kann in dieser Ausführungsform also gleichzeitig zur Energieversorgung und Ansteuerung für die Schalter dienen. Der Vorteil ist hierbei, dass die Schalter, insbesondere die Niedervoltschaltelemente, dann durch den Aufbau der emulierten Zellen bereits galvanisch mit hoher Isolationsfestigkeit voneinander getrennt sind. Werden die Schalter anderweitig mit Energie versorgt und angesteuert, so kann es nötig sein, eine zusätzliche, teure galvanische Trennung zwischen den Schaltern vorzusehen.

Bevorzugt ist vorgesehen, dass die Vorrichtung einen Anschluss für ein Steuergerät aufweist, welcher als mehrpolige Steckvorrichtung ausgebildet ist und über den die zumindest eine emulierte Größe zur Verfügung gestellt wird. Die Steckvorrichtung kann z. B. als mehrpolige Buchse einer Buchse-Stecker Kombination vorgesehen sein. Die emulierte Größe wird dem Steuergerät über den Anschluss zur Verfügung gestellt. In dieser Ausführungsform sind die Abgriffe zum Anschluss des Kalibriernormals über die Schaltvorrichtung vorgesehen und der Anschluss zum Austausch von Daten und emulierten Größen mit dem Steuergerät.

Darüber hinaus wird vorgesehen, dass das Kalibriernormal über die Schaltvorrichtung durch Schaltvorgänge nacheinander mit jeweils einer der emulierten Zellen verbunden wird.

Auch wird vorgeschlagen, dass an den Abgriffen der emulierten Zellen eine Spannung als emulierte Größe abgreifbar ist und das Kalibrieren eine Spannungsmessung an den mit dem Kalibriernormal verbundenen Abgriffen umfasst. Ausführungsbeispiele des Gegenstands der Anmeldung sind in der Zeichnung dargestellt und werden in der nachfolgenden Beschreibung näher erläutert.

Es zeigen
Fig. 1 ein Blockschaltbild der Vorrichtung in Verbindung mit dem Kalibriernormal und dem Steuergerät, das geprüft wird,
Fig. 2 eine erste nicht unter den Schutzumfang der Ansprüche fallende Ausführung der Schaltvorrichtung zwischen dem Batterieemulator und dem Kalibriernormal,
Fig. 3 eine zweite Ausführung der Schaltvorrichtung zwischen dem Batterieemulator und dem Kalibriernormal,
Fig. 4 ein Flussdiagramm des Verfahrens zum Kalibrieren des Batterieemulators und
Fig. 5 ein Anschlussfeld eines Batterieemulators.

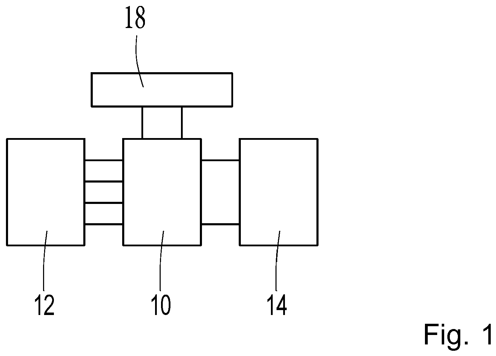

Fig. 1 zeigt in einer Übersicht den Batterieemulator 12, der über die Schaltvorrichtung 10 mit dem Kalibriernormal 14 verbunden ist. Über die Schaltvorrichtung 10 ist das Steuergerät 18 bspw. für die Regelung der Batterie, als Teil eines sogenannten Batteriemanagementsystems BMS, ebenso anschließbar. Es ist alternativ möglich, dass das Steuergerät 18 auch direkt an die Zellen oder an andere Anschlüsse der Schaltvorrichtung 10 jeweils anschließbar ist.

Der Batterieemulator 12 liefert als Emulation verschiedenste Ausgangsspannungsverläufe und/oder Ausgangsstromverläufe, die eine reale Batterie ausgeben kann. Damit wird die Funktionalität des Steuergeräts 18 getestet und es können ggfs. Parameter der darauf ausgeführten Software-Funktionen eingestellt werden.

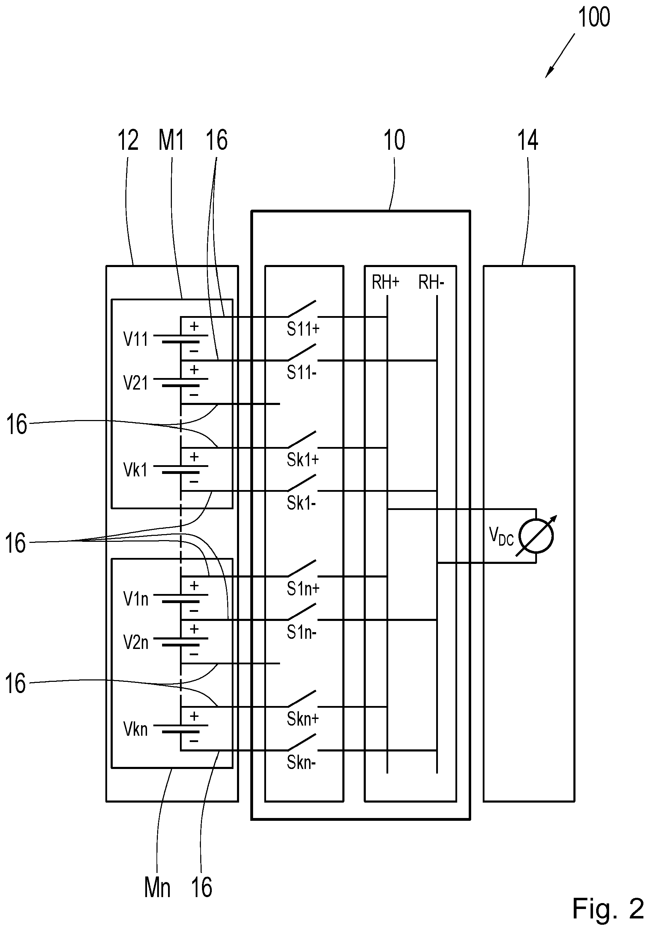

Fig. 2 zeigt die Vorrichtung in einer ersten nicht unter den Schutzumfang der Ansprüche fallenden Ausführung.

Dabei ist der Batterieemulator 12 über die Schaltvorrichtung 10 mit dem Kalibriernormal 14 verbunden. Jeweilige Abgriffe 16 der jeweiligen emulierten Zellen V11...Vkn, die zur Messung der Gleichspannung paarweise vorhanden sind, sind an jeweilige Schaltelemente oder Schalter bspw. S11+ und S11- angeschlossen.

Diese Schalter S11+, S11- bis Skn+, Skn- sind als Hochvolt-Schaltelemente ausgebildet. Insbesondere sind sie auch als elektromechanische Schaltelemente ausgebildet. Die Verbindung zwischen den jeweiligen Abgriffen 16 und den jeweiligen Schaltelementen S11+, S11- bis Skn+, Skn- kann dabei je nach Bedarf dauerhaft, bspw. durch eine stoffschlüssige Verbindung, oder lösbar, bspw. durch aufgesteckte Kabel, ausgeführt sein.

Die emulierten Zellen V11-Vkn können dabei in emulierte Zellgruppen M1-Mn zusammengefasst sein. Damit ist es möglich, solche Gruppen M1-Mn separat zu emulieren und das Steuergerät 18 mit bspw. unterschiedlichem Verhalten solcher Gruppen M1-Mn zu konfrontieren.

Die Schaltelemente S11-Skn sind in der Schaltvorrichtung 10 mit Hochvoltbusschienen RH+ und RH- verbunden, wobei auf die richtige Polarität zu achten ist. Die Spannungen an den einzelnen Schaltelementen S11 bis Skn addieren sich an den Hochvoltbusschienen RH+ und RH-, so dass an diesen Hochvoltbusschienen RH+ und RH- dann mehrere hundert Volt anliegen können. Die Hochvoltbusschienen RH+ und RH- können ein Hochvoltnetz in einem elektrisch angetriebenen Fahrzeug darstellen, an das dann Wechsel- und Gleichrichter für unterschiedliche Zwecke angeschlossen werden können. Es ist aber eben auch das Steuergerät 18 an diese Hochvoltbusschienen RH+ und RH- angeschlossen, um die elektrische Energieversorgung der angeschlossenen Komponenten zu steuern.

An die Hochvoltbusschienen RH+ und RH- ist das Kalibriernormal 14 angeschlossen, das vorliegend einen Spannungsmesser V_{DC} aufweist

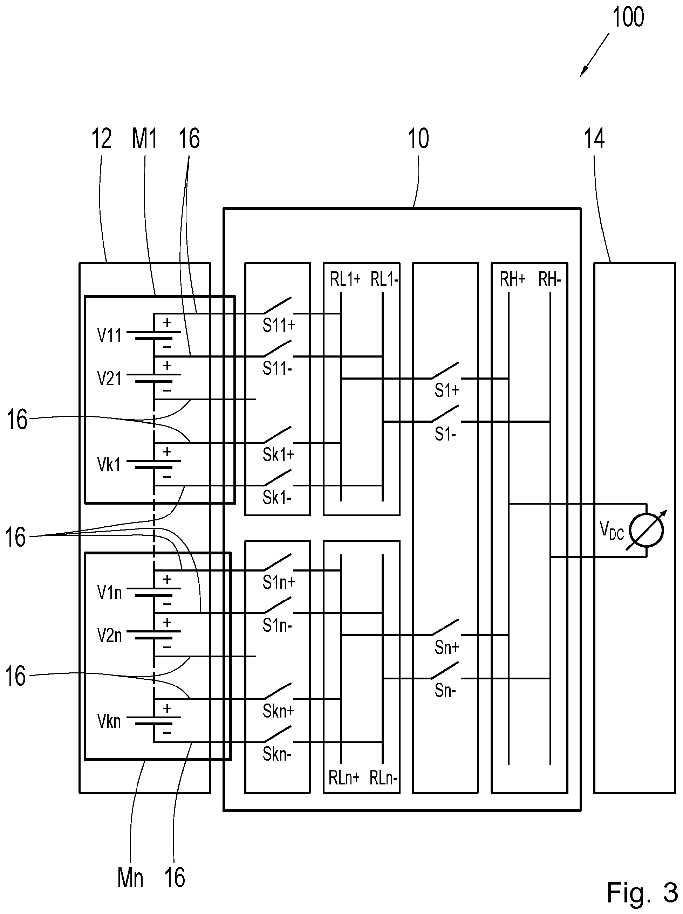

Fig. 3 zeigt eine zweite Ausführung der Schaltvorrichtung 10, die zwischen dem Batterieemulator 12 und dem Kalibriernormal 14 angeordnet ist. Wiederum sind Schaltelemente S11-Skn an die jeweiligen Abgriffe der Zellen V11 bis Vkn angeschlossen. Nunmehr verbinden diese Schalter S11-Skn jede Gruppe M1-Mn mit einem jeweiligen Paar von Niedervoltbusschienen RL1-RLn. Dabei ist eine Schiene bspw. RL1+ für das positive Potenzial und die andere Schiene RL1-des jeweiligen Paares für das negative Potenzial der Ausgangsspannung der jeweiligen Zellgruppe M1-Mn vorgesehen. An diese Niedervoltbusschienen ist auf der anderen Seite jeweils ein Paar von Schaltelementen S1+, S1- bis Sn+, Sn- vorgesehen, die die Niedervoltbusschienen RL1-RLn mit den Hochvoltbusschienen RH+ und RH- verbinden. Auch diese Schaltelemente S1-Sn können als elektromechanische Schalter ausgebildet sein.

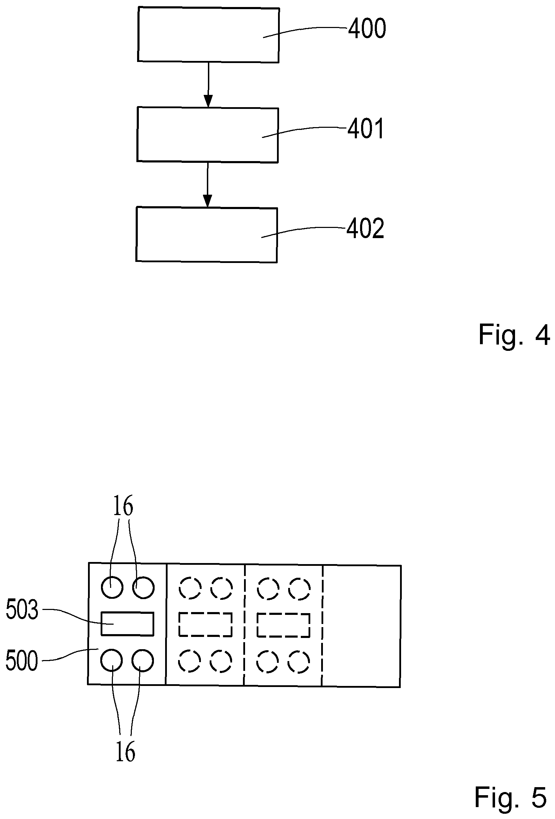

Fig. 4 zeigt ein Flussdiagramm des Verfahrens zum Kalibrieren eines Batterieemulators gemäß der Anmeldung. Dabei wird in Verfahrensschritt 400 der Batterieemulator 12 gestartet, um programmgemäß Ausgangsspannungen und -ströme einer realen Batterie auszugeben. In Verfahrensschritt 401 wird der Batterieemulator 12 über die Schaltvorrichtung 10 mit dem Kalibriernormal 14 verbunden. Dafür werden die Schaltelemente in der Schaltvorrichtung 10 entsprechend angesteuert. Mit dem Kalibriernormal 14 werden dann durch Vergleich die einzelnen Zellen mit Nennwerten verglichen. Ggfs. wird ein Eingriff vorgenommen, um die emulierten Zellen entsprechend einzustellen. Diese Schritte führt dann ein nicht dargestellter Rechner aus. In Verfahrensschritt 402 kann dann die Prüfung des Steuergeräts 18 vorgenommen werden. Dieser Rechner kann Teil der Vorrichtung 100 sein, bspw. als Element des Batterieemulators 12 oder der Schaltvorrichtung 10. Insbesondere kann der Rechner ausgebildet sein, eine Kalibrierung des Batterieemulators 12 automatisch auszuführen, z. B. gesteuert durch auf dem Rechner gespeicherte Befehle eines Algorithmus. Typischerweise kann es auch ein, ggf. können es auch mehrere miteinander kommunizierende Rechner im BMS HIL System sein, der oder die sowohl die Steuerung des Batterieemulators 12, der Schaltvorrichtung 10 und des Kalibriernormals 14 übernehmen.

Fig. 5 zeigt ein Anschlussfeld AF eines Batterieemulators 12. Dabei können pro Einschub 500 zwei emulierte Zellen vorgesehen sein, an die jeweils ein Paar von Abgriffen 16 angeschlossen wird. Über die Abgriffe 16 kann die Schaltvorrichtung 10 und an die Schaltvorrichtung 10 kann ein Kalibriernormal 14 angeschlossen werden. Ein mittiger Anschluss 503 für den Anschluss des Steuergerätes 18 ist ebenfalls vorgesehen. Die emulierte Größe der Zellen, wird sowohl über die Abgriffe 16 als auch den Anschluss 503 zur Verfügung gestellt. Neben dem Einschub 500 folgen dann in der Regel baugleiche weitere Einschübe, die ebenfalls jeweils zwei Zellen emulieren.

In einer weiteren Ausführungsform ist die Schaltvorrichtung 10 und das Kalibriernormal 14 in das Gehäuse des Batterieemulators 12 integriert. Dies bedeutet, dass der Batterieemulator 12, die Schaltvorrichtung 10 und das Kalibriernormal 14 in dem gleichen Gehäuse angeordnet sind. Die Abgriffe 16 sind innerhalb des Gehäuses angeordnet und müssen nicht zum Zweck der Kalibrierung zusätzlich nach außen geführt werden. Die Kalibrierung und Justierung des Batterieemulators 12 kann dann innerhalb des Gehäuses durchgeführt werden, ohne dass außerhalb des Gehäuses Verbindung mit dem Kalibriernormal 14 hergestellt werden muss. Bei dem Anschlussfeld AF von Figur 5 können dann die Abgriffe 16 entfallen.

### Bezugszeichenliste

- 10: Schaltvorrichtung
- 12: Batterieemulator
- 14: Kalibriernormal
- 16: Abgriffe
- 18: Steuergerät
- 100: Vorrichtung
- V11, V21, ..., Vk1, ..., V1n, V2n, Vkn: emulierte Zellen
- S11+,S11-,,Sk1+, Sk1-..., S1n+,S1n-,, Skn+, Skn-: Schaltelemente
- S1+, S1-, ... Sn+, Sn-: Schaltelemente
- RH+, RH-: Hochvolt-Busschienen
- RL1+, RL1-, ..., RLn+, RLn-: Niedervolt-Busschienen
- V_{DC}: Spannungsmesser
- M1, ..., Mn: Zellgruppe
- 400-402: Verfahrensschritte
- 500: Einschub
- 503: Anschluss

## Patentansprüche

1. Vorrichtung (100) zum Kalibrieren eines Batterieemulators (12), welcher eine Hochvolt-Batterie mit mehreren in Reihe geschalteten Zellen (V11, V21, ..., Vk1, ..., V1n, V2n, Vkn) emuliert, wobei jede emulierte Zelle (V11, V21, ..., Vk1, ..., V1n, V2n, Vkn) Abgriffe (16) aufweist, über die zumindest eine emulierte Größe abgreifbar ist, wobei die Vorrichtung (100) eine Schaltvorrichtung (10) aufweist, über die ein Kalibriernormal (14) mit verschiedenen Abgriffen (16) umschaltbar verbindbar ist,
wobei die emulierte Größe eine Spannung ist und das Kalibriernormal (14) einen Spannungsmesser (V_{DC}) aufweist, welcher mit einem Paar Hochvolt-Busschienen (RH+, RH-) der Schaltvorrichtung (10) verbunden ist und eingerichtet ist, eine zwischen den Hochvolt-Busschienen (RH+, RH-) anliegende Spannung zu messen,
wobei die Abgriffe (16) jeweils einer emulierten Zelle (V11, V21, ..., Vk1, ..., V1n, V2n, Vkn) über ein Paar Schaltelemente (S11+, S11-, ..., Sk1+, Sk1-..., S1n+, S1n-, ..., Skn+, Skn-) oder mehrere Paare von Schaltelementen S11+, S11-, ..., Sk1+, Sk1-..., S1n+, S1n-, ..., Skn+, Skn-, S1+, S1-, ... Sn+, Sn-) der Schaltvorrichtung (10) mit den Hochvolt-Busschienen (RH+, RH-) verbindbar sind,
**dadurch gekennzeichnet, dass**
die Schaltvorrichtung (10) mehrere Paare Niedervolt-Busschienen (RL1+, RL1-, ..., RLn+, RLn-) aufweist, welche jeweils paarweise über jeweils ein Paar Hochvoltschaltelemente (S1+, S1-, ... Sn+, Sn-) mit den Hochvolt-Busschienen (RH+, RH-) verbindbar sind.

2. Vorrichtung nach Anspruch 1, wobei das Kalibriernormal (14) mit den Abgriffen (16) von jeweils einer emulierten Zelle (V11, V21, ..., Vk1, ..., V1n, V2n, Vkn) verbindbar ist und diese Verbindung zu anderen emulierten Zellen (V11, V21, ..., Vk1, ..., V1n, V2n, Vkn) umschaltbar ist.

3. Vorrichtung nach Anspruch 1 oder 2, wobei die Schaltvorrichtung (10) Schaltelemente (S11+, S11-, ..., Sk1+, Sk1-..., S1n+, S1n-, ..., Skn+, Skn, S1+, S1-, ... Sn+, Sn-) aufweist und die Verbindung zwischen den Abgriffen (16) jeweils einer emulierten Zelle (V11, V21, ..., Vk1, ..., V1n, V2n, Vkn) und dem Kalibriernormal (14) ein oder mehrere Paare von Schaltelementen (S11+, S11-, ..., Sk1+, Sk1-..., S1n+, S1n-, ..., Skn+, Skn, S1+, S1-, ... Sn+, Sn-) in Reihe aufweist.

4. Vorrichtung nach Anspruch 3, wobei die Schaltelemente (S11+, S11-, ..., Sk1+, Sk1-..., S1n+, S1n-, ..., Skn+, Skn, S1+, S1-, ... Sn+, Sn-) als elektromechanische Schaltelemente ausgebildet sind.

5. Vorrichtung nach Anspruch 4, wobei mehrere in Reihe geschaltete emulierte Zellen (V11, V21, ..., Vk1, ..., V1n, V2n, Vkn) über jeweils ein Paar Niedervoltschaltelemente (S11+, S11-, ..., Sk1+, Sk1-..., S1n+, S1n-, ..., Skn+, Skn) mit einem Paar Niedervolt-Busschienen (RL1+, RL1-, ..., RLn+, RLn-) verbindbar sind.

6. Vorrichtung nach Anspruch 5, wobei der Batterieemulator (14) mehrere in Reihe und/oder in Serie geschaltete Zellgruppen (M1-n)) emuliert, welche jeweils mehrere in Reihe geschaltete Zellen (V11, V21, ..., Vk1, ..., V1n, V2n, Vkn) emulieren, wobei die emulierten Zellen (V11, V21, ..., Vk1, ..., V1n, V2n, Vkn) einer emulierten Zellgruppe (M1-n) über jeweils ein Paar Niedervoltschaltelemente (S11+, S11-, ..., Sk1+, Sk1-..., S1n+, S1n-, ..., Skn+, Skn) mit den Niedervolt-Busschienen (RL1+, RL1-, ..., RLn+, RLn-) verbindbar sind.

7. Vorrichtung nach einem der vorhergehenden Ansprüche, weiter aufweisend den Batterieemulator (12) und das Kalibriernormal (14).

8. Vorrichtung zum Kalibrieren nach Anspruch 7, wobei die Schaltvorrichtung (10), der Batterieemulator (12) und das Kalibriernormal (14) in einem Gehäuse angeordnet sind.

9. Vorrichtung zum Kalibrieren nach einem der vorhergehenden Ansprüche, wobei die Vorrichtung (100) einen Anschluss (503) für ein Steuergerät (18) aufweist, welcher als mehrpolige Steckvorrichtung ausgebildet ist und über den die zumindest eine emulierte Größe zur Verfügung gestellt wird.

10. Verfahren zum Kalibrieren eines Batterieemulators (12), welcher eine Hochvolt-Batterie mit mehreren in Reihe geschalteten Zellen (V11, V21, ..., Vk1, ..., V1n, V2n, Vkn) emuliert, wobei jede emulierte Zelle (V11, V21, ..., Vk1, ..., V1n, V2n, Vkn) Abgriffe (16) aufweist, über die zumindest eine emulierte Größe abgreifbar ist, wobei ein Kalibriernormal (14) über eine Schaltvorrichtung (10) nacheinander mit verschiedenen Abgriffen (16) verbunden wird,
wobei die emulierte Größe eine Spannung ist und das Kalibriernormal (14) einen Spannungsmesser (V_{DC}) aufweist, welcher mit einem Paar Hochvolt-Busschienen (RH+, RH-) der Schaltvorrichtung (10) verbunden wird und eine zwischen den Hochvolt-Busschienen (RH+, RH-) anliegende Spannung misst,
wobei die Abgriffe (16) jeweils einer emulierten Zelle (V11, V21, ..., Vk1, ..., V1n, V2n, Vkn) über ein Paar Schaltelemente (S11+, S11-, ..., Sk1+, Sk1-..., S1n+, S1n-, ..., Skn+, Skn-) oder mehrere Paare von Schaltelementen S11+, S11-, ..., Sk1+, Sk1-..., S1n+, S1n-, ..., Skn+, Skn-, S1+, S1-, ... Sn+, Sn-) der Schaltvorrichtung (10) mit den Hochvolt-Busschienen (RH+, RH-) verbunden werden, und
wobei die Schaltvorrichtung (10) mehrere Paare Niedervolt-Busschienen (RL1+, RL1-, ..., RLn+, RLn-) aufweist, welche jeweils paarweise über jeweils ein Paar Hochvoltschaltelemente (S1+, S1-, ... Sn+, Sn-) mit den Hochvolt-Busschienen (RH+, RH-) verbunden werden.

11. Verfahren nach Anspruch 10, wobei das Kalibriernormal (14) über die Schaltvorrichtung (10) durch Schaltvorgänge nacheinander mit jeweils einer der emulierten Zellen (V11, V21, ..., Vk1, ..., V1n, V2n, Vkn) verbunden wird.

12. Verfahren nach Anspruch 10 oder 11, wobei an den Abgriffen (16) der emulierten Zellen (V11, V21, ..., Vk1, ..., V1n, V2n, Vkn) eine Spannung als emulierte Größe abgreifbar ist und das Kalibrieren eine Spannungsmessung an den mit dem Kalibriernormal (14) verbundenen Abgriffen (16) umfasst.

## Claims

1. A device (100) for calibrating a battery emulator (12) for emulating a high-voltage battery having a plurality of series-connected cells (V11, V21, ..., Vk1, ..., V1n, V2n, Vkn), each emulated cell (V11, V21, ..., Vk1, ..., V1n, V2n, Vkn) having taps (16) by means of which at least one emulated variable can be tapped, the device (100) having a switching device (10) by means of which a calibration standard (14) can be switchably connected to various taps (16),
the emulated variable being a voltage and the calibration standard (14) having a voltmeter (V_{DC}) connected to a pair of high-voltage busbars (RH+, RH-) of the switching device (10) and configured to measure a voltage present between the high-voltage busbars (RH+, RH-),
the taps (16) of each emulated cell (V11, V21, ..., Vk1, ..., V1n, V2n, Vkn) being able to be connected to the high-voltage busbars (RH+, RH-) by means of a pair of switching elements (S11+, S11-, ..., Sk1+, Sk1-..., S1n+, S1n-, ..., Skn+, Skn-) or a plurality of pairs of switching elements (S11+, S11-, ..., Sk1+, Sk1-..., S1n+, S1n-, ..., Skn+, Skn-, S1+, S1-, ... Sn+, Sn-) of the switching device (10),
**characterized in that** the switching device (10) has a plurality of pairs of low-voltage busbars (RL1+, RL1-, ..., RLn+, RLn-), each of which can be connected to the high-voltage busbars (RH+, RH-) in pairs by means of a respective pair of high-voltage switching elements (S1+, S1-, ... Sn+, Sn-).

2. The device according to claim 1, wherein the calibration standard (14) can be connected to the taps (16) of a respective emulated cell (V11, V21, ..., Vk1, ..., V1n, V2n, Vkn) and said connection can be switched to other emulated cells (V11, V21, ..., Vk1, ..., V1n, V2n, Vkn).

3. The device according to claim 1 or 2, wherein the switching device (10) has switching elements (S11+, S11-, ..., Sk1+, Sk1-..., S1n+, S1n-, ..., Skn+, Skn, S1+, S1-, ... Sn+, Sn-) and the connection between the taps (16) of each emulated cell (V11, V21, ..., Vk1, ..., V1n, V2n, Vkn) and the calibration standard (14) has one or more pairs of switching elements (S11+, S11-, ..., Sk1+, Sk1-..., S1n+, S1n-, ..., Skn+, Skn, S1+, S1-, ... Sn+, Sn-) in series.

4. The device according to claim 3, wherein the switching elements (S11+, S11-, ..., Sk1+, Sk1-..., S1n+, S1n-, ..., Skn+, Skn, S1+, S1-, ... Sn+, Sn-) are implemented as electromechanical switching elements.

5. The device according to claim 4, wherein a plurality of emulated cells (V11, V21, ..., Vk1, ..., V1n, V2n, Vkn) connected in series can be connected to a pair of low-voltage busbars (RL1+, RL1-, ..., RLn+, RLn-) by means of one pair each of low-voltage switching elements (S11+, S11-, ..., Sk1+, Sk1-..., S1n+, S1n-, ..., Skn+, Skn).

6. The device according to claim 5, the battery emulator (14) emulating a plurality of cell groups (M1-n) connected in series, each of which emulates a plurality of cells (V11, V21, ..., Vk1, ..., V1n, V2n, Vkn) connected in series, wherein the emulated cells (V11, V21, ..., Vk1, ..., V1n, V2n, Vkn) of an emulated cell group (M1-n) can be connected to the low-voltage busbars (RL1+, RL1-, ..., RLn+, RLn-) by means of a respective pair of low-voltage switching elements (S11+, S11-, ..., Sk1+, Sk1-..., S1n+, S1n-, ..., Skn+, Skn).

7. The device according to any one of the preceding claims, further comprising the battery emulator (12) and the calibration standard (14).

8. The calibration device according to claim 7, wherein the switching device (10), the battery emulator (12), and the calibration standard (14) are disposed in a housing.

9. The calibration device according to any one of the preceding claims,
wherein the device (100) has a connection (503) for a control unit (18) implemented as a multipole plug-in device and by means of which the at least one emulated variable is made available.

10. A method for calibrating a battery emulator (12) emulating a high-voltage battery having a plurality of cells (V11, V21, ..., Vk1, ..., V1n, V2n, Vkn) connected in series, each emulated cell (V11, V21, ..., Vk1, ..., V1n, V2n, Vkn) having taps (16) by means of which at least one emulated variable can be tapped, a calibration standard (14) being successively connected to various taps (16) by means of a switching device (10),
the emulated variable being a voltage and the calibration standard (14) comprising a voltmeter (V_{DC}) connected to a pair of high-voltage busbars (RH+, RH-) of the switching device (10) and measuring a voltage present between the high-voltage busbars (RH+, RH-),
the taps (16) of a respective emulated cell (V11, V21, ..., Vk1, ..., V1n, V2n, Vkn) being connected to the high-voltage busbars (RH+, RH-) by means of a pair of switching elements (S11+, S11-, ..., Sk1+, Sk1-..., S1n+, S1n-, ..., Skn+, Skn-) or a plurality of pairs of switching elements (S11+, S11-, ..., Sk1+, Sk1-..., S1n+, S1n-, ..., Skn+, Skn-, S1+, S1-, ... Sn+, Sn-) of the switching device (10), and
wherein the switching device (10) comprises a plurality of pairs of low-voltage busbars (RL1+, RL1-, ..., RLn+, RLn-), each connected to the high-voltage busbars (RH+, RH-) in pairs by means of a respective pair of high-voltage switching elements (S1+, S1-, ... Sn+, Sn-).

11. The method according to claim 10, wherein the calibration standard (14) is successively connected to one of the emulated cells (V11, V21, ..., Vk1, ..., V1n, V2n, Vkn) by switching operations in each case by means of the switching device (10).

12. The method according to claim 10 or 11, wherein a voltage can be tapped as an emulated variable at the taps (16) of the emulated cells (V11, V21, ..., Vk1, ..., V1n, V2n, Vkn) and the calibration comprises a voltage measurement at the taps (16) connected to the calibration standard (14).

## Revendications

1. Dispositif (100) d'étalonnage d'un émulateur de batterie (12) qui émule une batterie haute tension comportant plusieurs cellules (V11, V21, ..., Vk1, ..., V1n, V2n, Vkn) branchées en série, chaque cellule (V11, V21, ..., Vk1, ..., V1n, V2n, Vkn) émulée comportant des prises (16) par le biais desquelles au moins une grandeur émulée peut être prélevée, le dispositif (100) comportant un dispositif de commutation (10) par le biais duquel un étalon d'étalonnage (14) peut être relié de manière commutable à différentes prises (16),
la grandeur émulée étant une tension et l'étalon d'étalonnage (14) comportant un voltmètre (V_{DC}) qui est connecté à une paire de barres de bus haute tension (RH+, RH-) du dispositif de commutation (10) et qui est conçu pour mesurer une tension appliquée entre les barres de bus haute tension (RH+, RH-),
les prises (16) de chaque cellule (V11, V21, ..., Vk1, ..., V1n, V2n, Vkn) émulée pouvant être reliées aux barres de bus haute tension (RH+, RH-) par l'intermédiaire d'une paire d'éléments de commutation (S11+, S11-, ..., Sk1+, Sk1-..., S1n+, S1n-, ..., Skn+, Skn-) ou de plusieurs paires d'éléments de commutation (S11+, S11-, ..., Sk1+, Sk1-..., S1n+, S1n-, ..., Skn+, Skn-, S1+, S1-, ... Sn+, Sn-) du dispositif de commutation (10),
**caractérisé en ce que** le dispositif de commutation (10) comporte plusieurs paires de barres de bus basse tension (RL1+, RL1-, ..., RLn+, RLn-), lesquelles peuvent être reliées, respectivement par paires, aux barres de bus haute tension (RH+, RH-) respectivement par le biais d'une paire d'éléments de commutation haute tension (S1+, S1-, ... Sn+, Sn-).

2. Dispositif selon la revendication 1, l'étalon d'étalonnage (14) pouvant être relié aux prises (16) de, respectivement, une cellule (V11, V21, ..., Vk1, ..., V1n, V2n, Vkn) émulée et cette liaison pouvant être commutée vers d'autres cellules (V11, V21, ..., Vk1, ..., V1n, V2n, Vkn) émulées.

3. Dispositif selon la revendication 1 ou 2, le dispositif de commutation (10) comportant des éléments de commutation (S11+, S11-, ..., Sk1+, Sk1-..., S1n+, S1n-, ..., Skn+, Skn, S1+, S1-, ... Sn+, Sn-) et la liaison entre les prises (16) respectives d'une cellule (V11, V21, ..., Vk1, ..., V1n, V2n, Vkn) émulée et l'étalon d'étalonnage (14) comportant une ou plusieurs paires d'éléments de commutation (S11+, S11-, ..., Sk1+, Sk1-..., S1n+, S1n-, ..., Skn+, Skn, S1+, S1-, ... Sn+, Sn-) en série.

4. Dispositif selon la revendication 3, les éléments de commutation (S11+, S11-, ..., Sk1+, Sk1-..., S1n+, S1n-, ..., Skn+, Skn, S1+, S1-, ... Sn+, Sn-) étant réalisés sous la forme d'éléments de commutation électromécaniques.

5. Dispositif selon la revendication 4, plusieurs cellules (V11, V21, ..., Vk1, ..., V1n, V2n, Vkn) émulées branchées en série pouvant être reliées à une paire de barres de bus basse tension (RL1+, RL1-, ..., RLn+, RLn-) respectivement par le biais d'une paire d'éléments de commutation basse tension (S11+, S11-, ..., Sk1+, Sk1-..., S1n+, S1n-, ..., Skn+, Skn).

6. Dispositif selon la revendication 5, l'émulateur de batterie (14) émulant plusieurs groupes de cellules (M1-n) branchées en série, lesquels émulent respectivement plusieurs cellules (V11, V21, ..., Vk1, ..., V1n, V2n, Vkn) branchées en série, les cellules (V11, V21, ..., Vk1, ..., V1n, V2n, Vkn) émulées d'un groupe de cellules (M1-n) émulé pouvant être reliées aux barres de bus basse tension (RL1+, RL1-, ..., RLn+, RLn-) respectivement par le biais d'une paire d'éléments de commutation basse tension (S11+, S11-, ..., Sk1+, Sk1-..., S1n+, S1n-, ..., Skn+, Skn).

7. Dispositif selon l'une des revendications précédentes, comportant en outre l'émulateur de batterie (12) et l'étalon d'étalonnage (14).

8. Dispositif d'étalonnage selon la revendication 7, le dispositif de commutation (10), l'émulateur de batterie (12) et l'étalon d'étalonnage (14) étant disposés dans un boîtier.

9. Dispositif d'étalonnage selon l'une des revendications précédentes, le dispositif (100) comportant une borne (503) pour un appareil de commande (18), laquelle est réalisée sous la forme d'un dispositif enfichable multipolaire et par l'intermédiaire duquel est mise à disposition l'au moins une grandeur émulée.

10. Procédé d'étalonnage d'un émulateur de batterie (12), lequel émule une batterie haute tension comprenant plusieurs cellules (V11, V21, ..., Vk1, ..., V1n, V2n, Vkn) branchées en série, chaque cellule (V11, V21, ..., Vk1, ..., V1n, V2n, Vkn) émulée comportant des prises (16) par le biais desquelles au moins une grandeur émulée peut être prélevée, un étalon d'étalonnage (14) étant relié successivement à différentes prises (16) par le biais d'un dispositif de commutation (10),
la grandeur émulée étant une tension et l'étalon d'étalonnage (14) comportant un voltmètre (V_{DC}), lequel est connecté à une paire de barres de bus haute tension (RH+, RH-) du dispositif de commutation (10) et mesure une tension appliquée entre les barres de bus haute tension (RH+, RH-),
les prises (16) de chaque cellule (V11, V21, ..., Vk1, ..., V1n, V2n, Vkn) émulée étant reliées aux barres de bus haute tension (RH+, RH-) par l'intermédiaire d'une paire d'éléments de commutation (S11+, S11-, ..., Sk1+, Sk1-..., S1n+, S1n-, ..., Skn+, Skn-) ou de plusieurs paires d'éléments de commutation (S11+, S11-, ..., Sk1+, Sk1-..., S1n+, S1n-, ..., Skn+, Skn-, S1+, S1-, ... Sn+, Sn-) du dispositif de commutation (10), et
le dispositif de commutation (10) comportant plusieurs paires de barres de bus basse tension (RL1+, RL1-, ..., RLn+, RLn-), lesquelles sont reliées, respectivement par paires, aux barres de bus haute tension (RH+, RH-) respectivement par le biais d'une paire d'éléments de commutation haute tension (S1+, S1-, ... Sn+, Sn-).

11. Procédé selon la revendication 10, l'étalon d'étalonnage (14) étant relié successivement, par l'intermédiaire du dispositif de commutation (10) par des opérations de commutation, respectivement à l'une des cellules (V11, V21, ..., Vk1, ..., V1n, V2n, Vkn) émulées.

12. Procédé selon la revendication 10 ou 11, une tension pouvant être prélevée en tant que grandeur émulée aux prises (16) des cellules (V11, V21, ..., Vk1, ..., V1n, V2n, Vkn) émulées et l'étalonnage comprenant une mesure de tension aux prises (16) reliées à l'étalon d'étalonnage (14).
